(19) Europäisches Patentamt
European Patent Office
Office européen des brevets

(11) **EP 4 343 847 A1**

(12) **EUROPEAN PATENT APPLICATION**
published in accordance with Art. 153(4) EPC

(43) Date of publication:
**27.03.2024 Bulletin 2024/13**

(21) Application number: **22816420.8**

(22) Date of filing: **31.05.2022**

(51) International Patent Classification (IPC):
**H01L 27/32** (2006.01)        **G06V 40/13** (2022.01)
**H01L 27/146** (2006.01)        **H01L 51/52** (2006.01)

(52) Cooperative Patent Classification (CPC):
**G06F 18/00; G06V 40/13; H01L 27/146;**
**H10K 50/80; H10K 59/00**

(86) International application number:
**PCT/KR2022/007701**

(87) International publication number:
**WO 2022/255761 (08.12.2022 Gazette 2022/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **03.06.2021 KR 20210072273**

(71) Applicant: **Samsung Electronics Co., Ltd.
Suwon-si, Gyeonggi-do 16677 (KR)**

(72) Inventor: **KIM, Jinho
Suwon-si Gyeonggi-do 16677 (KR)**

(74) Representative: **HGF
HGF Limited
1 City Walk
Leeds LS11 9DX (GB)**

(54) **ELECTRONIC DEVICE COMPRISING FINGERPRINT SENSOR AND METHOD**

(57) An electronic device according to various embodiments of the disclosure may include a fingerprint sensor, a display including a fingerprint detection region corresponding to a region in which the fingerprint sensor is disposed and a fingerprint non-detection region distinct from the fingerprint sensor detection region, wherein the fingerprint detection region of the display include a light-emitting element layer including a pixel region and a non-pixel region around the pixel region, and a first layer disposed on an upper side of the light-emitting element layer and including a first region overlapping the pixel region and a second region overlapping the non-pixel region, and a printed pattern disposed on at least one of the non-pixel region and the second region, wherein the printed pattern includes a plurality of light-transmitting holes through which light reflected by an external object passes.

FIG.6A

**EP 4 343 847 A1**

**Description**

**[Technical Field]**

Various embodiments of the disclosure relate to an electronic device including a fingerprint sensor and a method thereof.

**[Background Art]**

In order to increase a display region of a screen on a front side of an electronic device such as a smart phone, an area of a display disposed to the front side of the electronic device is increased. Due to the increase in the area of the display, optical sensors such as an illuminance sensor, a camera module, or a fingerprint sensor, which is disposed on an edge of the display or disposed on a rear side of the electronic device, may be disposed adjacent to the display. The electronic device may include an in-display type fingerprint sensor disposed to a rear side of a display to recognize a user's fingerprint in a screen region of a front display.

**[Disclosure of Invention]**

**[Technical Problem]**

When fingerprint detection is performed in at least some regions on a display through a fingerprint sensor, the fingerprint sensor may irradiate light to a fingerprint and receive light reflected from the fingerprint to obtain a fingerprint image.

Therefore, in order for an in-display type fingerprint sensor, which may be disposed to a rear side of a display, to obtain a correct fingerprint image without distortion, a display transmittance representing a rate at which light reflected from the fingerprint passes through the display may serve as an importance performance indicator. Specifically, it may be important to design a display structure such that the light reflected from the fingerprint passes while decreasing diffraction pattern noise which may occur when the light reflected from the fingerprint passes through the display, as well as simply increasing the rate at which the light reflected by the fingerprint passes through the display.

**[Solution to Problem]**

According to various embodiments of the disclosure, an electronic device may include a fingerprint sensor, a display including a fingerprint detection region corresponding to a region in which the fingerprint sensor is disposed and a fingerprint non-detection region distinct from the fingerprint sensor detection region, wherein the fingerprint detection region of the display includes a light-emitting element layer including a pixel region and a non-pixel region around the pixel region, and a first layer disposed on an upper side of the light-emitting element layer and including a first region overlapping the pixel region and a second region overlapping the non-pixel region, and a printed pattern disposed on at least one of the non-pixel region and the second region, wherein the printed pattern includes a plurality of light-transmitting holes through which light reflected by an external object passes.

A display module according to various embodiments of the disclosure may include a fingerprint sensor, a display including a fingerprint detection region corresponding to a region in which the fingerprint sensor is disposed and a fingerprint non-detection region distinct from the fingerprint sensor detection region, wherein the fingerprint detection region includes a light-emitting element layer including a pixel region and a non-pixel region around the pixel region, and a first layer disposed on an upper side of the light-emitting element layer and including a first region overlapping the pixel region and a second region overlapping the non-pixel region, and a printed pattern disposed on at least one of the non-pixel region and the second region, wherein the printed pattern includes a plurality of light-transmitting holes through which light reflected by an external object passes.

**[Advantageous Effects of Invention]**

According to an embodiment of the disclosure, an in-display type fingerprint sensor disposed to a rear side of a display may be used to obtain a uniform fingerprint image, thereby obtaining correct fingerprint data.

According to an embodiment of the disclosure, a printed pattern for increasing a light transmittance of a display may be disposed without having to increase a volume of an electronic device including an optical fingerprint sensor.

In addition thereto, various effects which are directly or indirectly understood through the disclosure may be provided.

[Brief Description of Drawings]

FIG. 1 is a front perspective view of an electronic device having a fingerprint recognition function, according to an embodiment;

FIG. 2 briefly illustrates a display of an electronic device having a fingerprint recognition function, according to an embodiment;

FIG. 3A briefly illustrates a first region of a display (e.g., a region in which a fingerprint sensor is not disposed), according to an embodiment;

FIG. 3B briefly illustrates a second region of a display (e.g., a region in which a fingerprint sensor is disposed), according to an embodiment;

FIG. 4 is a block diagram of an electronic device having a fingerprint recognition function, according to an embodiment;

FIG. 5 illustrates a printed pattern disposed to a second region of a display, according to an embodiment;

FIG. 6A illustrates an arrangement of a printed pattern in a second region of a display, according to an embodiment;

FIG. 6B illustrates an arrangement of a printed pattern in a second region of a display, according to an embodiment;

FIG. 6C illustrates an arrangement of a printed pattern in a second region of a display, according to an embodiment;

FIG. 7A illustrates a first region of a display and a second region of the display, according to another embodiment;

FIG. 7B illustrates a first region of a display and a second region of the display, according to another embodiment;

FIG. 8 illustrates a printed pattern and a diffraction pattern produced when light reflected by an external object passes through the printed pattern, according to an embodiment;

FIG. 9 illustrates a relative arrangement between a fingerprint sensor and a diffraction pattern, according to an embodiment;

FIG. 10 illustrates a moire pattern produced in a process in which light reflected by an external object is received in a fingerprint sensor, according to an embodiment;

FIG. 11 illustrates an arrangement of a printed pattern configured to reduce a moiré pattern included in an image obtained through a fingerprint sensor, according to an embodiment; and

FIG. 12 is a block diagram of an electronic device in a network environment, according to various embodiments.

[Mode for Carrying out the Invention]

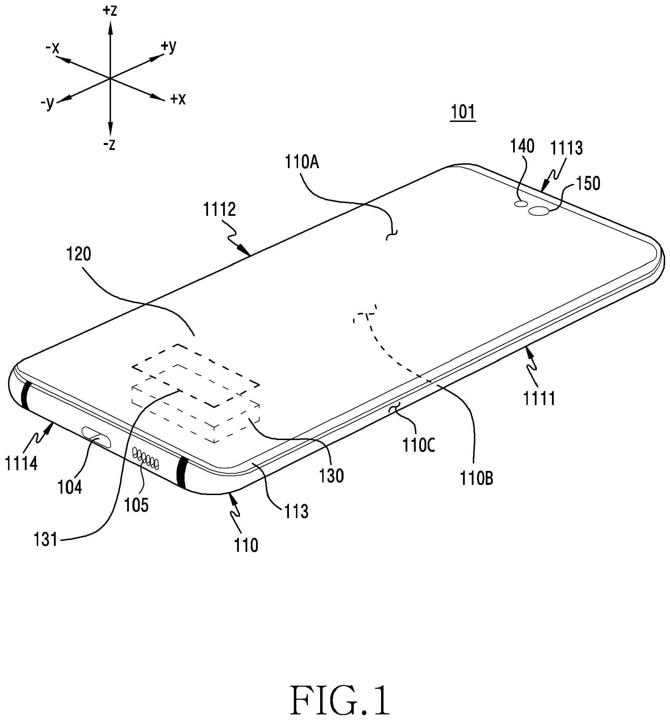

FIG. 1 is a front perspective view of an electronic device 101, according to an embodiment.

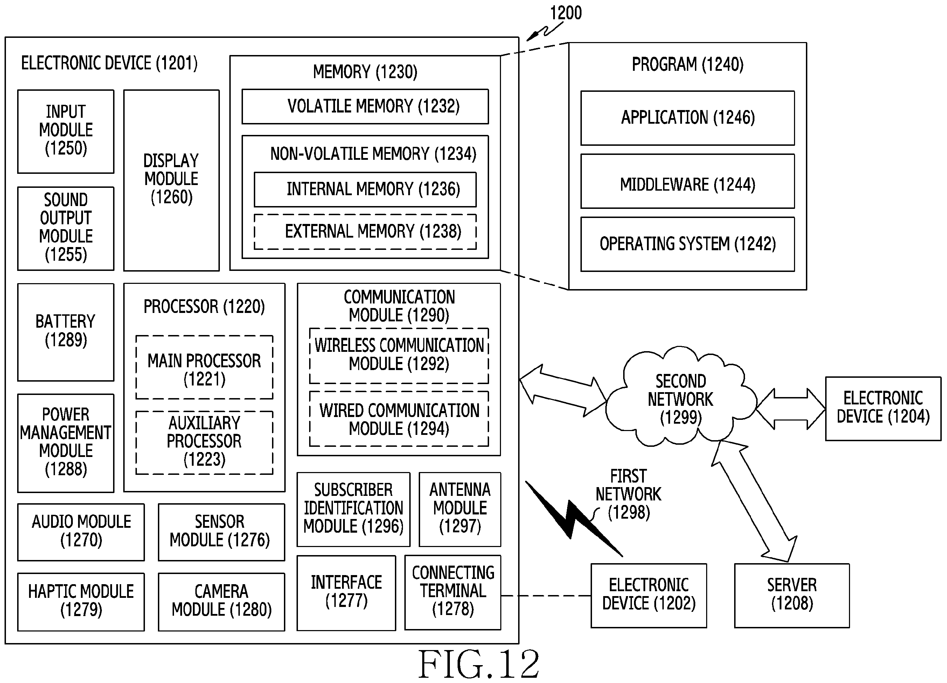

The electronic device 101 of FIG. 1 may correspond to an electronic device 1201 of FIG. 12 described below. For example, the electronic device 101 may include some or all of components constituting the electronic device 1201 of FIG. 12.

Referring to FIG. 1, an electronic device of a bar type is disclosed for example as the electronic device 101 according to an embodiment of the disclosure. However, the disclose is also applicable to electronic devices of other types such as slidable, rollable, and/or foldable types. The electronic device according to various embodiments may be one of electronic devices of various types. The electronic device may include, for example, a wearable device or a home appliance. The electronic device according to an embodiment of the disclosure is not limited to the aforementioned devices.

Referring to FIG. 1, the electronic device 101 according to an embodiment may include a housing 110 including a first side (or a front side) 110A, a second side (or a rear side) 110B facing the first side, and a lateral side (or a lateral wall) 110C surrounding a space between the first side 110A and the second side 110B. In another embodiment, the housing 110 may refer to a construction which constitutes part of the first side 110A, second side 110B, and lateral side 110C of FIG. 1.

According to an embodiment, the first side 110A may be constructed of a front plate 113 (e.g., a polymer plate or a glass plate including various coating layers) which is substantially transparent at least in part. In an example, the front plate 113 may include a curved portion seamlessly extended by being bent from the first side 110A toward the second side 110B in at least one side edge portion.

In an embodiment, the second side 110B may be constructed of a rear plate (not shown) which is substantially opaque. In an example, the rear plate (not shown) may be constructed of coated or colored glass, ceramic, polymer, metallic materials (e.g. aluminum, stainless steel (STS), or magnesium) or a combination of at least two of these materials. In an example, the rear plate may include a curved portion seamlessly extended by being bent from the second side 110B toward the front plate 113 in at least one side edge portion.

In an embodiment, the lateral side 110C may be coupled to the front plate 113 and the rear plate (not shown) and may be constructed by a lateral member (or a lateral bezel structure or a lateral wall) including metal or polymer. In an example, the lateral side 110C may include a first lateral side 1111 located to the right (e.g., +x direction of FIG.

1) of the electronic device 101 and extending along a first direction (e.g., +y direction of FIG. 1), a second lateral side 1112 substantially parallel to the first lateral side 1111 and extending along the first direction, a third lateral side 1113 extending along a second direction (e.g., +x direction of FIG. 1) substantially perpendicular to the first direction and coupling one end of the first lateral side 1111 (e.g., one end in +y direction of FIG. 1) and one end of the second lateral side 1112 (e.g., one end in +y direction of FIG. 1), and/or a fourth lateral side 1114 substantially parallel to the third lateral side 1113 and coupling the other end of the first lateral side 1111 (e.g., one end in -y direction of FIG. 1) and the other end of the second lateral side 1112 (e.g., one end in -y direction of FIG. 1).

According to an embodiment, the electronic device 101 may include at least one or more of a display 120, a connector hole 104, an audio module 105, a first optical module 140, and a second optical module 150. In an example, at least one of components may be omitted or other components may be additionally included in the electronic device 101. For example, the electronic device 101 may additionally include a sensor module (not shown). The electronic device 101 may include a key input device (not shown).

In an embodiment, in a region provided by the front plate 113, a sensor such as a proximity sensor, an image sensor, or an iris sensor may be integrated into the display 120 or may be disposed adjacent to the display 120.

In an embodiment, the display 120 may be exposed through some portions of the front plate 113. In an example, the display 120 may be disposed adjacent to or joined with a touch sensing circuitry, a pressure sensor capable of measuring touch strength (pressure), and/or a digitizer for detecting a magnetic-type stylus pen. In an example, a corner of the display 120 may be constructed to be substantially identical to an outer shape (e.g., a curved side) adjacent to the front plate 113.

In an embodiment, the display 120 may include a plurality of pixels (PX). Each of the plurality of pixels (PX) may include at least one light emitting element. The electronic device 101 may drive the plurality of pixels (PX) according to image data input from the outside to display an image through a screen display region of the display 120.

In an embodiment, the screen display region may be constructed with the exposure of the display 120. For example, the screen display region may include the first side 110A.

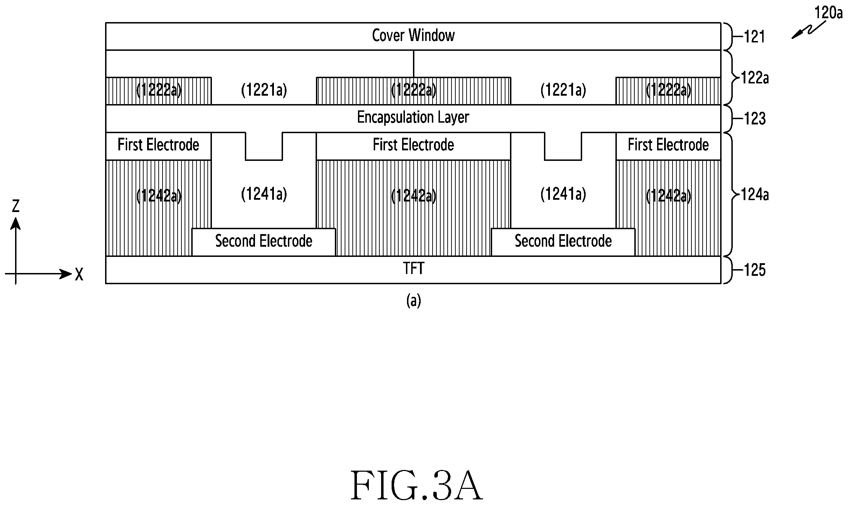

In an embodiment, the first side 110A of the display 120 may include a fingerprint detection region 131 and a fingerprint non-detection region (e.g., a fingerprint non-detection region 120a of FIG. 3A) distinct from the fingerprint detection region 131.

Referring to FIG. 1, the first side 110A may include the fingerprint detection region 131 configured to obtain user's bio information (e.g., fingerprint information). In an example, the fingerprint detection region 131 may include a region corresponding to a region in which a fingerprint sensor 130 is disposed.

In an embodiment, the first side 110A may include the fingerprint non-detection region in which the fingerprint sensor 130 is not disposed, at a lower portion of the display 120.

In an embodiment, the electronic device 101 may obtain fingerprint information of an external object detected through the fingerprint detection region 131. In an example, the fingerprint detection region 131 may be a region overlapping the fingerprint sensor 130 disposed to the lower portion of the display 120 (e.g., at least one region in -z direction). For example, similarly to other regions of the screen display region 110A, the fingerprint detection region 131 may be a region capable of displaying visual information by means of the display 120 and capable of additionally obtaining the user's bio information (e.g., fingerprint information). The fingerprint detection region 131 may be displayed directly on the display 120, or may not be displayed.

In an embodiment, when the display 120 is viewed in -z axis direction, the fingerprint sensor 130 may partially overlap the plurality of pixels (PX).

In an embodiment, the fingerprint sensor 130 may include an optical sensor (e.g., an image sensor), and may detect that light output from the light source is reflected by a user's finger. The fingerprint sensor 130 may analyze the reflected light to detect the user's fingerprint. In an example, the fingerprint sensor 130 disposed adjacent to the display 120 may use at least one light emitting element included in the plurality of pixels (PX) as the light source.

In an embodiment, the first optical module 140 and/or second optical module 150 of the electronic device 101 may be disposed to a region overlapping at least one region of the display 120, when the display 120 is viewed in -z axis direction. The first optical module 140 and/or the second optical module 150 may be disposed by being imbedded in the display 120. In an example, the first optical module 140 may include an illuminance sensor. The second optical module 150 may include a camera module.

In an embodiment, the first optical module 140 may be disposed to overlap at least one region of the display 120, when a front side of the housing 110 is viewed in an upper portion (e.g., +z axis direction). The first optical module 140 may be disposed to a rear side (e.g., -z direction) of the display 120. In an example, the first optical module 140 may be disposed to a portion adjacent to the second optical module 150. Although it is illustrated in FIG. 1 that the first optical module 140 is disposed at an upper center of the display 120, the disclosure is not limited thereto. For example, the first optical module 140 may be disposed to an upper right or left portion of the display 120.

In an embodiment, the first optical module 140 may measure external illuminance by using intensity of light incident from the outside. The first optical module 140 may receive external light to measure illuminance of an environment in which the electronic device 101 is located.

In an embodiment, the second optical module 150 may include a plurality of cameras. In an example, the second optical module 150 may include one or more lenses, an image sensor, and/or an image processor.

In an embodiment, the connector hole 104 may house a connector for transmitting/receiving power and/or data of an external electronic device (e.g., electronic devices 1202 and 1204 of FIG. 12) and/or a connector for transmitting/receiving an audio signal with respect to the external electronic device. For example, the connector hole 104 may include a USB connector or an earphone jack (not shown) (or an "earphone interface"). In an embodiment, the USB connector and the earphone jack may be implemented as one hole. In another embodiment, the electronic device 101 may transmit/receive power and/or data with respect to an external electronic device without an additional connector hole, or may transmit/receive an audio signal.

In an embodiment, the audio module 105 may include a microphone hole and a speaker hole. The microphone hole may have a microphone disposed inside thereof to acquire external sound, and a plurality of microphones may be disposed inside thereof to detect a direction of the sound. In another example, the speaker hole and the microphone hole may be implemented as one hole, or the speaker may be included without the speaker hole. The speaker hole may include an external speaker hole and a communication receiver hole.

In an embodiment, the electronic device 101 may include a sensor module (not shown) to create an electrical signal or data value corresponding to an internal operational state or an external environment state. The electronic device 101 may further include at least one of a plurality of sensor modules (not shown), for example, a gesture sensor, a gyro sensor, an atmospheric pressure sensor, a magnetic sensor, an acceleration sensor, a grip sensor, a color sensor, an Infrared (IR) sensor, a temperature sensor, and a humidity sensor.

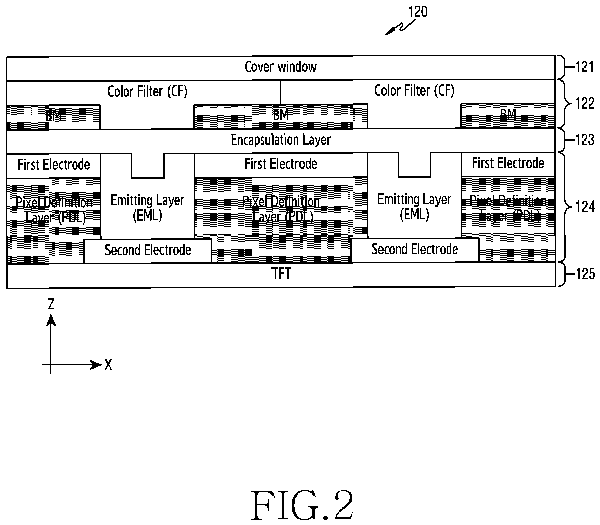

FIG. 2 briefly illustrates the display 120 of the electronic device 101 having a fingerprint recognition function, according to an embodiment.

In an embodiment, a light emitting element layer 124 may be disposed to an upper portion (e.g., in +z direction of FIG. 2) of a Thin Film Transistor (TFT) layer 125. The light emitting element layer 124 may include at least one light emitting element connected to at least one TFT of the TFT layer 125. The light emitting element layer 124 may include an organic light emitting layer. The light emitting element may be an organic light emitting element (e.g., an organic light emitting diode). The light emitting element may include a first electrode (cathode, CD), an Emitting Layer (EML), and a second electrode (anode, AD). The first electrode (CD) may be a cathode electrode, and the second electrode (AD) may be an anode electrode. Various embodiments of the disclosure are not limited thereto, and the first electrode may be the anode electrode and the second electrode may be the cathode electrode.

In an embodiment, the EML may be disposed on an exposed surface (e.g., in +z direction of FIG. 2) of the second electrode (AD). The EML may have a multilayer thin film structure including a light generation layer. For example, the EML may have a hole injection layer which injects holes, a hole transport layer which has excellent hole transport properties and suppresses movement of electrons failing in combination in the light generation layer to increase a chance to recombine holes and electrons, a light generation layer which emits light due to recombination of injected electrons and holes, a hole blocking layer for suppressing movement of holes failing in recombination in the light generation layer, an electrons transport layer for smoothly transporting electrons to the light generation layer, and/or an electron injection layer which injects electrons.

In an embodiment, the light emitting element layer 124 may generate any one of red, green and blue light beams. However, the light emitting element layer 124 is not limited thereto, and may generate a white light beam by combining organic materials which generate red, greed, and/or blue colors.

In an embodiment, the light emitting element layer 124 may include a Pixel Definition Layer (PDL) disposed between an EML and another EML. The PDL may include an organic insulating material.

In an embodiment, the PDL may include a material which does not transmit light. For example, the PDL may be a light blocking material containing chromium (Cr) or chromium oxide (CrOx) or a light blocking layer containing carbon or black pigments.

In an embodiment, an encapsulation layer 123 may be disposed to an upper portion (e.g., +z direction of FIG. 2) of the light emitting element layer 124. The encapsulation layer 123 may include a plurality of insulating films covering the light emitting element layer 124. For example, the encapsulation layer 123 may include a plurality of inorganic films and/or organic films. The encapsulation layer 123 may have a structure in which inorganic films and/or organic films are alternately stacked.

For example, the encapsulation layer 123 may include encapsulation glass or a Thin Film Encapsulation (TFE). The TFE may be implemented with soft organic materials, but a type thereof is not limited thereto.

In an embodiment, the encapsulation layer 123 may prevent oxygen or moisture from penetrating into the light emitting element layer 124.

In an embodiment, a Touch Sensor Panel (TSP) (not shown) may be disposed to an upper portion (e.g., in +z direction of FIG. 2) of the encapsulation layer 123.

In an embodiment, a first layer 122 may be disposed to an upper portion (e.g., +z direction of FIG. 2) of the encapsulation layer 123. In an example, the first layer 122 may be a layer for absorbing external light. In an example, the first layer 122 may include a Color Filter (CF) and a Black Matrix (BM).

In an embodiment, the CF may have any one of red, green, and blue colors like the light emitting element. The CF may convert external light into any one of red, green, and blue colors. For example, external light provided from a plurality of pixels (PX) toward a pixel (PX) may be converted into any one of red, green, and blue colors in the CF. When the CF is not disposed, the external light may be at least partially reflected by the pixel (PX) and thus may be visible to a user. The visibility of the external light may be prevented by the CF.

In an embodiment, the BM may be included in the first layer 122. In an example, the BM may be disposed between CFs to distinguish a plurality of CFs. The BM may include a light absorbing material to absorb light. The BM may prevent a region other than a light emitting region in which light is emitted through the EML from being visible from the outside.

In an embodiment, a cover window 121 may be disposed to an upper portion (e.g., +z direction of FIG. 2) of the first layer 122. In an example, the cover window 121 may be attached to the upper portion of the first layer 122 through an adhesive member (not shown).

In an embodiment, the cover window 121 may be directly in contact with a user' finger. In an example, when the user's finger is in contact with the cover window 121, light output from the light emitting element layer 124 may be reflected by ridges or valleys of the finger, and the reflected light may be reachable to a fingerprint sensor.

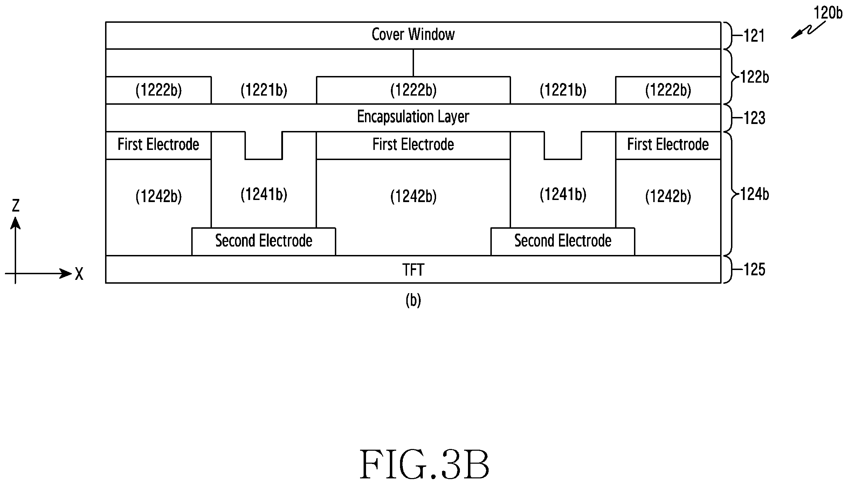

FIG. 3A briefly illustrates the fingerprint non-detection region 120a of the display 120 (e.g., a region in which the fingerprint sensor 130 is not disposed to a lower portion). FIG. 3B briefly illustrates a fingerprint detection region 120b of the display 120 (e.g., a region in which at least some portions of the fingerprint sensor 130 are disposed to a lower portion). In an example, the fingerprint detection region 120b may correspond to the fingerprint detection region 131 of FIG. 1.

In an embodiment, the display 120 may include the fingerprint non-detection region 120a and the fingerprint detection region 120b. The fingerprint non-detection region 120a may be a region in which the fingerprint sensor 130 does not overlap the plurality of pixels (PX), when the display 120 is viewed in -z axis direction. The fingerprint detection region 120b may be a region in which the fingerprint sensor 130 partially overlaps the plurality of pixels (PX), when the display 120 is viewed in -z axis direction.

In an embodiment, the fingerprint non-detection region 120a may include a first layer 122a and a light emitting element layer 124a, and the fingerprint detection region 120b may include a first layer 122b and a light emitting element layer 124b. Other structures may be applied in the same manner as those described for the display 120 of FIG. 2.

Referring to FIG. 3A, the light emitting element layer 124a in the fingerprint non-detection region 120a may include a pixel region 1241a in which light is output and a non-pixel region 1242a around the pixel region. In an example, an EML may be disposed to the pixel region 1241a, and a PDL may be disposed to the non-pixel region 1242a.

In an embodiment, the PDL disposed to the non-pixel region 1242a may include various materials having light blocking properties. For example, the PDL disposed to the non-pixel region 1242a may include black dye. Since the PDL disposed to the non-pixel region 1242a includes various materials having light blocking properties, it is possible to absorb a reflective component of external light to prevent the reflective component of the external light from being visible to a user.

In an embodiment, the first layer 122a in the fingerprint non-detection region 120a may include the first region 1221a corresponding to a pixel region 1241a and a second region 1222a corresponding to the non-pixel region 1242a. In an example, a CF may be disposed to the first region 1221a, and a BM may be disposed to the second region 1222a.

In an embodiment, the BM disposed to the second region 1222a may include various materials having light blocking properties such as a PDL disposed to the non-pixel region 1242a.

Referring to FIG. 3B, the light emitting element layer 124b in the fingerprint detection region 120b may include a pixel region 1241b in which light is output and a non-pixel region 1242b around the pixel region. In an example, an EML may be disposed to the pixel region 1241b, and a PDL may be disposed to the non-pixel region 1242b.

In an embodiment, the first layer 122b in the fingerprint detection region 120b may include a first region 1221b corresponding to the pixel region 1241b and a second region 1222b corresponding to the non-pixel region 1242b. In an example, a CF may be disposed to the first region 1221b.

In an embodiment, in order to increase a light transmittance of the display 120, a PDL disposed to the non-pixel region 1242b and a material disposed to the second region 1222b may include a material in which a light blocking material is removed or a light absorbing material is removed, so that light reflected by an external object (e.g., a user' finger) passes through the display 120 and reaches the fingerprint sensor 130.

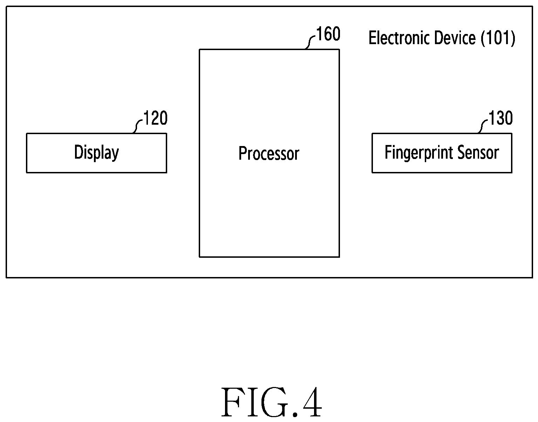

FIG. 4 is a block diagram of the electronic device 101 having a fingerprint recognition function, according to an embodiment.

Referring to FIG. 4, the electronic device 101 may include the display 120, the fingerprint sensor 130, and/or a processor 160.

In an embodiment, the display 120 may visually output information to a user through the display 120 based on an Organic Light Emitting Diode (OLED), but without being limited thereto, may visually output the information to the user, based on at least one of a Quantum dot Light Emitting Diode (QLED), a Liquid Crystal Display (LCD), and a Light Emitting Diodes (LED).

In an embodiment, the electronic device 101 may include a Touch Sensor Panel (TSP) disposed above the display 120 to more intuitively control a user interface which is output through the display 120. For example, the TSP may be implemented in an add-on type in which the TSP is disposed above the display 120 or an on-cell type or in-cell type in which the TSP is disposed inside the display 120. The TSP may use at least one of a resistive film, a capacitive component, a surface acoustic wave, and infrared light to detect a position of an object (e.g., a user's finger or a stylus pen) which touches the display 120 or hovers on the display 120.

In an embodiment, the electronic device 101 may use the fingerprint sensor 130 to obtain user's fingerprint information.

In an embodiment, the fingerprint sensor 130 may be disposed to a rear side of the display 120 or may be disposed inside the display 120. In an example, the fingerprint sensor 130 may be disposed substantially parallel to the display 120.

In an embodiment, the fingerprint sensor 130 may use light emitted from the display 120 to detect a pattern of an external object. The display 120 may function as a light source for an operation of the fingerprint sensor 130.

In an embodiment, the fingerprint sensor 130 may include a CMOS Image Sensor (CIS), a Charge Coupled Device (CCD) image sensor, a TFT amorphous silicon image sensor, or an Organic Photodiode (OPD).

In an embodiment, the fingerprint sensor 130 may include at least one lens. The fingerprint sensor 130 may include a lens type sensor in which a lens magnification is substantially greater than 1x and a lensless type sensor in which there is no lens or the lens magnification is substantially 1x.

In an embodiment, a distance between a plurality of light transmission holes of a printed pattern 200 may be determined according to a lens disposed to the fingerprint sensor 130.

In an embodiment, the processor 160 may be electrically or operationally coupled to the display 120 or the fingerprint sensor 130. In an example, the processor 160 may use instructions stored in a memory (not shown) to control at least one of other components of the electronic device 101 and/or execute an arithmetic operation or data processing for communication. In an example, the processor 160 may have at least one of a Central Processing Unit (CPU), a Graphic Processing Unit (GPU), a Micro Controller Unit (MCU), a sensor hub, a supplementary processor, a communication processor, an application processor, an Application Specific Integrated Circuit (ASIC), a Field Programmable Gate Arrays (FPGA), and may have a plurality of cores.

In an embodiment, the processor 160 may use at least some of a plurality of pixels (PX) of the display 120 to supply a driving signal for fingerprint sensing. The driving signal may be provided so that at least some of the plurality of pixels (PX) of the display 120 emit light to operate as a light source for the fingerprint sensor 130. For example, the light source for the fingerprint sensor 130 may emit designated light of a set color (e.g., a bright color (e.g., white or green)) or a set brightness.

In an embodiment, the processor 160 may detect an input related to an external object (e.g., a part of a user's body) through a fingerprint detection region (e.g., the fingerprint detection region 131 of FIG. 1) disposed to at least one region of the display 120. For example, the processor 160 may determine whether the external object detected through the fingerprint detection region 131 corresponds to a part (e.g., a finger) of the user's body.

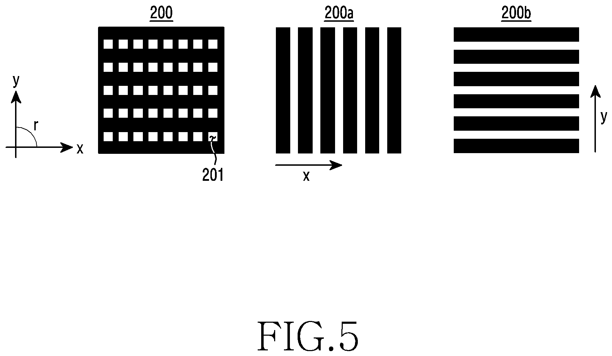

FIG. 5 illustrates the printed pattern 200 disposed to the fingerprint detection region 120b of the display 120, according to an embodiment.

In an embodiment, the display 120 may include the printed pattern 200. For example, light reflected from an external object may pass through the printed pattern 200 disposed to the fingerprint detection region 120b of the display 120.

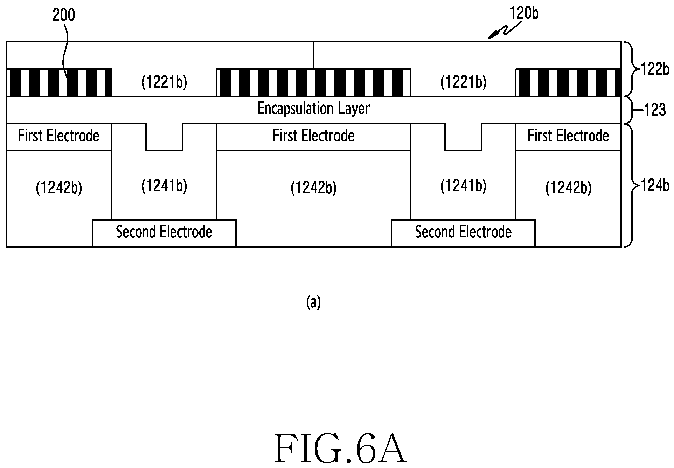

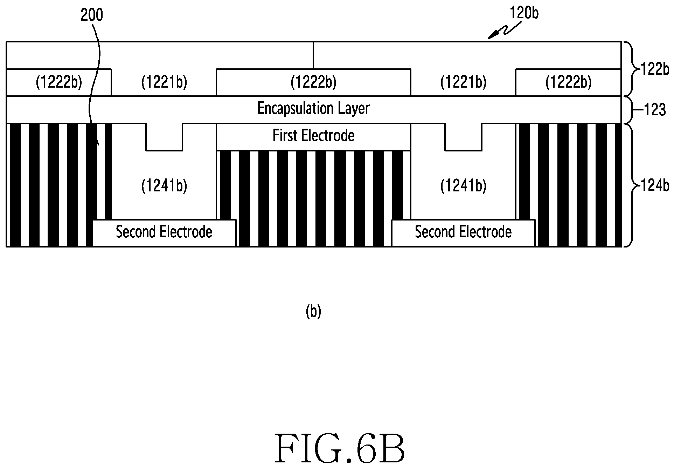

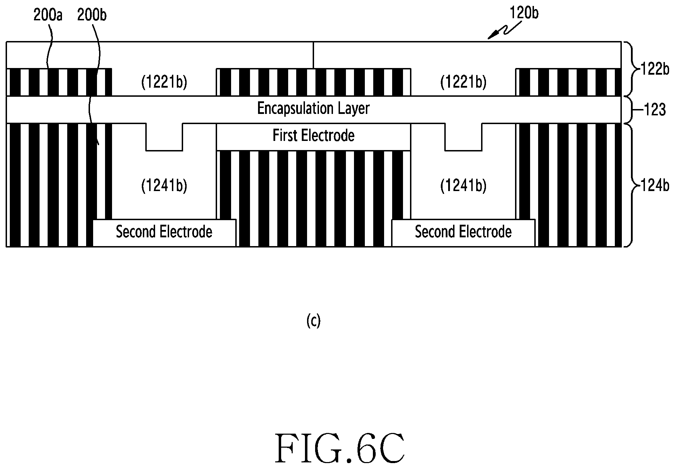

In an embodiment, in the fingerprint detection region 120b of the display 120, a region in which the printed pattern 200 is disposed will be described in detail with reference to FIG. 6A, FIG. 6B, and/or FIG. 6C.

In an embodiment, the printed pattern 200 may include a plurality of light transmission holes 201 so that light reflected from an external object passes therethrough.

In an embodiment, the printed pattern 200 may include a first printed pattern 200a and a second printed pattern 200b.

In an embodiment, the first printed pattern 200a may be a printed pattern arranged in a first direction (e.g., +x direction). The second printed pattern 200b may be a printed pattern arranged in a second direction (e.g., +y direction). In an example, the first printed pattern 200a and the second printed pattern 200b may be coupled. The first printed pattern 200a and the second printed pattern 200b may be constructed integrally.

In an embodiment, the plurality of light transmission holes 201 may be constructed by combining the first printed pattern 200a and the second printed pattern 200b.

In an embodiment, the plurality of light transmission holes 201 may be prepared to selectively transmit at least part of light incident to the display 120.

In an embodiment, the plurality of light transmission holes 201 may be constructed of a transparent material so that light passes therethrough.

In an embodiment, the plurality of light transmission holes 201 may not be disposed in a first direction (e.g., +x direction) and a second direction (e.g., +y direction). For example, the plurality of light transmission holes 201 may be disposed in various directions, and a shape and size thereof may change variously.

FIG. 6A, FIG. 6B, and FIG. 6C illustrate an arrangement of the printed pattern 200 in the fingerprint detection region 120b of the display 120, according to an embodiment.

Referring to FIG. 6A, the printed pattern 200 may be disposed to the second region 1222b of the first layer 122b.

Referring to FIG. 6B, the printed pattern 200 may be disposed to the non-pixel region 1242b of the light emitting element layer 124b.

Referring to FIG. 6C, the first printed pattern 200a may be disposed to the second region 1222b of the first layer 122b. The second printed pattern 200b may be disposed to the non-pixel region 1242b of the light emitting element layer 124b.

In another embodiment, the second printed pattern 200b may be disposed to the second region 1222b of the first layer 122b, and the first printed pattern 200a may be disposed to the non-pixel region 1242b of the light emitting element layer 124b.

In an embodiment, the first printed pattern 200a and/or the second printed pattern 200b may not be oriented in a first direction (e.g., +x direction of FIG. 5) and/or in a second direction (e.g., +y direction of FIG. 5).

In an embodiment, the printed pattern 200a disposed to the second region 1222b of the first layer 122b and the printed pattern 200b disposed to the non-pixel region 1242b of the light emitting element layer 124b may be the same printed pattern. In this case, the light transmission holes of the printed pattern 200a disposed to the second region 1222b and the printed pattern 200b disposed to the non-pixel region 1242b may be aligned with each other.

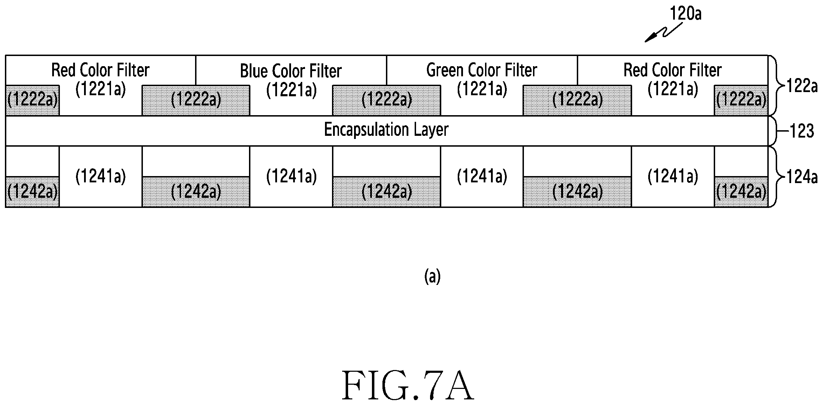

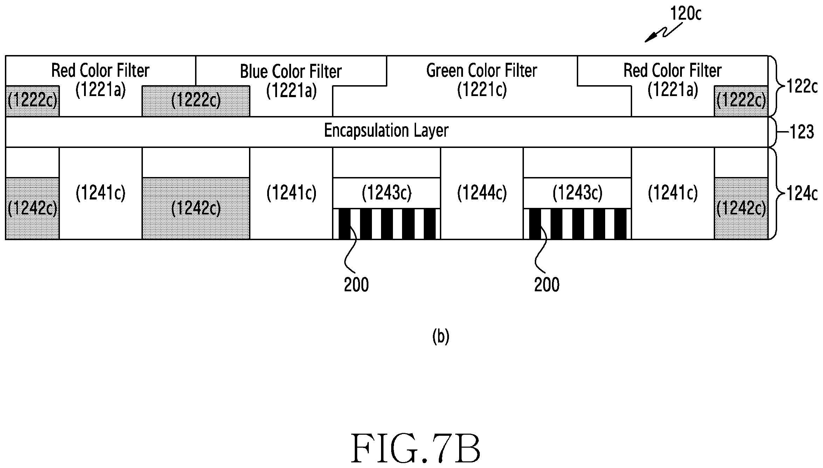

FIG. 7A and FIG. 7B illustrate a fingerprint non-detection region 120a of a display and a fingerprint detection region 120c of the display, according to another embodiment.

In an embodiment, the display 120 may include the fingerprint non-detection region 120a and the fingerprint detection region 120c. In an example, the fingerprint detection region 120c may differ from the fingerprint detection region 120b of FIGs. 6A to 6C in the shape of the color filter layer 122b, and other structures may be equally applied.

Referring to FIG. 7A, a color filter layer 122a in the fingerprint non-detection region 120a may have a red color filter, a blue color filter, and a green color filter sequentially arranged. In an example, when the red color filter is arranged, external light may be converted to red.

For convenience of explanations, although it is illustrated in case of FIG. 7A that the red color filter, the blue color filter, and the green color filter are all disposed in one cross-section, at least one of the red color filter, the blue color filter, and the green color filter may not be disposed to one cross-section.

Referring to FIG. 7B, the fingerprint detection region 120c of the display 120 may be a region partially overlapping a plurality of pixels (PX) in which the fingerprint sensor 130 is disposed.

In an embodiment, in a region in which the fingerprint detection region 120c partially overlaps the fingerprint sensor 130, the printed pattern 200 may not be disposed to any one of a second region 1222c of a color filter layer 122c and a non-pixel region 1242c of a light emitting element layer 124c.

In an embodiment, the fingerprint detection region 120c may include a first pixel region 1241c and a second pixel region 1244c. The printed pattern 200 may be disposed only to a second non-pixel region 1243c around the second pixel region 1244c, and a light blocking material may be included in the remaining regions, i.e., the first non-pixel region 1242c around the first pixel region 1241c and the second region 1222c of the color filter layer 122c. In an example, the second pixel region 1244c may be an EML which emits green light. The fingerprint sensor 130 may have better sensitivity to the EML which emits green light than to an EML which emits red or blue light. Therefore, it may be possible to reduce a size of a region in which the printed pattern 200 including a light transmission hole is disposed by constructing the printed pattern 200 including the light transmission hole only in the non-pixel region 1243c adjacent to the second pixel region 1244c which emits green light in the light emitting element layer 124c.

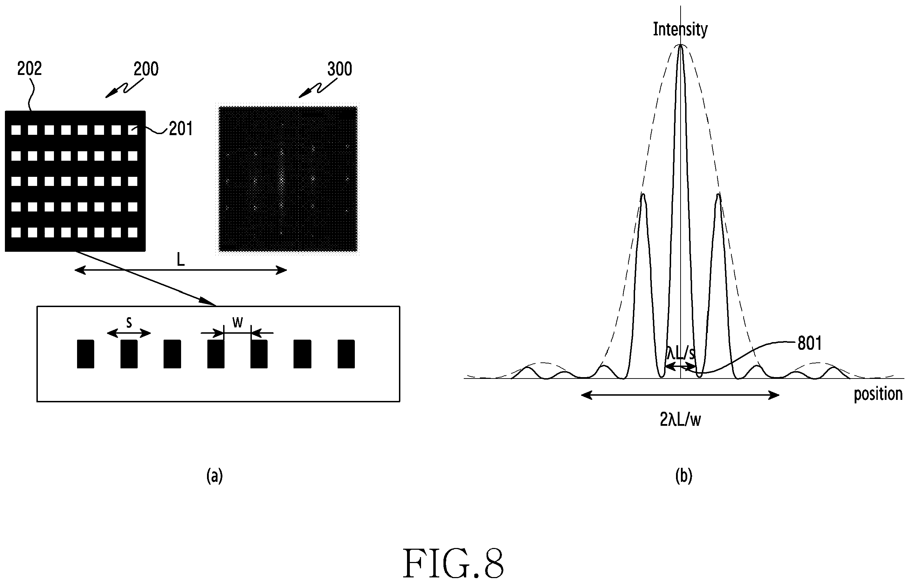

FIG. 8 illustrates the printed pattern 200 and a diffraction pattern 300 produced when light reflected by an external object passes through the printed pattern 200, according to an embodiment.

Referring to FIG. 8, the printed pattern 200 may include the plurality of light transmission holes 201 through which external light passes and a light blocking region 202 which constitutes the plurality of light transmission holes 201.

In an embodiment, the printed pattern 200 may be constructed of a rigid material or a flexible material.

In an embodiment, the plurality of light transmission holes 201 may be openings locally opened in the printed pattern 200. In an example, the light blocking region 202 may include an opaque metal or black matrix material.

In an embodiment, the number, shape, and/or arrangement of the plurality of light transmission holes 201 may change variously. For example, a distance 's' between the plurality of light transmission holes 201 may be determined based on a wavelength $\lambda$ of light reflected by the external object, a distance between the printed pattern and the fingerprint sensor, and a width of the fingerprint sensor.

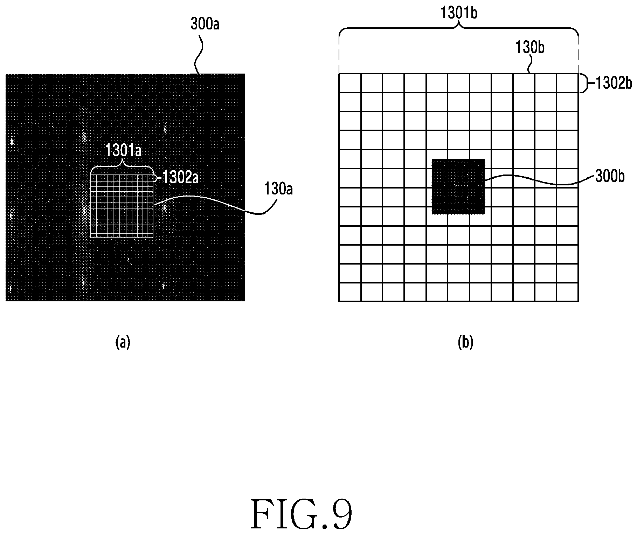

In an embodiment, the distance 's' between the plurality of light transmission holes 201 will be described in detail with reference to FIG. 9.

In an embodiment, the diffraction pattern 300 may be constructed due to light reflected by an external object passing through the plurality of light transmission holes 201.

In an embodiment, the diffraction pattern 300 may be constructed when light, which is a plane wave reflected by an external object, is transformed into a spherical wave while passing through the printed pattern 200, and thus interference occurs between the spherical waves. Therefore, when the light reflected by the external object passes through the printed pattern 200, the light may have irregular light intensity.

In an embodiment, a spacing 801 between successive bright patterns in the diffraction pattern 300 may be determined by Equation 1.

$$【\text{Equation 1}】$$

$$\Delta x = \lambda \times \mathrm{L}/s$$

Referring to Equation 1, $\Delta x$ may denote a spacing between successive patterns, $\lambda$ may denote a wavelength of light incident to the plurality of light transmission holes 201, L may denote a distance between the printed pattern 200 and the fingerprint sensor 130, and s may denote a spacing (or distance) between the plurality of light transmission holes 201.

FIG. 9 illustrates a relative arrangement between the fingerprint sensor 130 and the diffraction pattern 300, according to an embodiment.

In an embodiment, the fingerprint sensor 130 may include the fingerprint sensor 130a and the fingerprint sensor 130b.

In an embodiment, the fingerprint sensor 130a may include a lens-type lens having a magnification greater than 1x. In an example, the lens type may mean a lens type in which a width 1301a of the fingerprint sensor 130a is less than an area recognized by the magnification of the lens.

In an embodiment, the fingerprint sensor 130a may include the width 1301a of the fingerprint sensor 130a and a pixel size 1302a of the fingerprint sensor 130a.

In an embodiment, the fingerprint sensor 130b may include a lensless-type lens of which a magnification is substantially 1x.

In an embodiment, the fingerprint sensor 130b may include a width 1301b of the fingerprint sensor 130b and a pixel size 1302b of the fingerprint sensor 130b.

In an embodiment, the spacing between the plurality of light transmission holes of the printed pattern 200 may vary depending on the type of the lens included in the fingerprint sensor 130. In an example, a distance between a plurality of light transmission holes included in the printed pattern 200 when the fingerprint sensor 130a is disposed may be different from a distance between a plurality of light transmission holes included in the printed pattern 200 when the fingerprint sensor 130b is disposed.

FIG. 9A illustrates a case where a spacing between patterns included in the diffraction pattern 300a is designed to be greater than the width 1301a of the fingerprint sensor 130a.

In an embodiment, when the length-type fingerprint sensor 130a is disposed to a lower side of the display 120, the spacing between the patterns included in the diffraction pattern 300a may be designed to be greater than the width of the fingerprint sensor 130a. Referring to FIG. 9A, the fingerprint sensor 130a may be disposed between two successive bright patterns in the diffraction pattern 300a to obtain a uniform image by minimizing influence caused by the diffraction pattern 300a.

In an embodiment, the width 1301a of the fingerprint sensor 130a may be less than a spacing $\Delta x$ of two bright patterns so as to be disposed between a first bright pattern and a second bright pattern.

$$【\text{Equation 2}】$$

$$\Delta x = \lambda \times \frac{\mathrm{L}}{s} > \text{width of the fingerprint sensor (130)}$$

Referring to Equation 2, a distance 's' between the plurality of light transmission holes 201 may be obtained such that the fingerprint sensor 130a is located between two bright patterns. For example, if the wavelength $\lambda$ of light passing through the plurality of light transmission holes 201 is approximately 0.5 $\mu$m (approximately 500nm), a distance L between the printed pattern 200 and the fingerprint sensor 130a is approximately 4000 $\mu$m, and the width 1301a of the fingerprint sensor 130a is approximately 1000 μm, the distance 's' between the plurality of light transmission holes 201 may be designed to be less than approximately 2 μm.

In an embodiment, the diffraction pattern 300a may affect a fingerprint image obtained through the fingerprint sensor 130a to the minimum possible when disposed by moving it from a center portion of a sensor region of the fingerprint sensor 130a by half a period of the diffraction pattern 300a.

In an embodiment, a size w of the plurality of light transmission holes 201 may be designed to be greater than half the distance 's' between the plurality of light transmission holes 201 to increase a light transmittance.

FIG. 9B illustrates a case where a spacing between patterns included in the diffraction pattern 300b is designed to be less than the pixel size 1302b of the fingerprint sensor 130b.

In an embodiment, when the lensless-type fingerprint sensor 130b is disposed to a lower side of the display 120, the spacing between the patterns included in the diffraction pattern 300b may be designed to be less than the pixel size of the fingerprint sensor 130b. In an embodiment, since a magnification of the fingerprint sensor 130b is substantially close to 1x, the pixel size 1302b of the fingerprint sensor 130b may be greater than the pixel size 1302a of the lens-type fingerprint sensor 130a to obtain the same image resolution. Therefore, the pixel size 1302b of the lensless-type fingerprint sensor 130b may be designated to be greater than the spacing between the patterns included in the diffraction pattern 300b.

Referring to FIG. 9B, it may be assumed that the spacing between patterns included in the diffraction pattern 300b is designed to be less than the pixel size 1302b of the fingerprint sensor 130b.

In an embodiment, since a sampling frequency of a device shall be more than twice a frequency of information to be acquired according to a Nyquist sampling theory, a spacing $\Delta x$ between two successive bright patterns may be designed to be less than twice the pixel size 1302b of the fingerprint sensor 130b in order for the diffraction pattern 300b not to be detected by the fingerprint sensor 130b.

【Equation 3】

$$\Delta x = \lambda \times \frac{L}{s} < \text{ pixel size of the fingerprint sensor (130)} \times 2$$

For example, if the wavelength λ of light passing through the plurality of light transmission holes 201 is approximately 0.5 μm (approximately 500nm), the pixel size 1302b of the fingerprint sensor 130b is approximately 25μm, and a distance between the fingerprint sensor 130b and the printed pattern 200 corresponds to approximately 100 μm, the distance 's' between the plurality of light transmission holes 201 may be designed to be greater than approximately 1 μm.

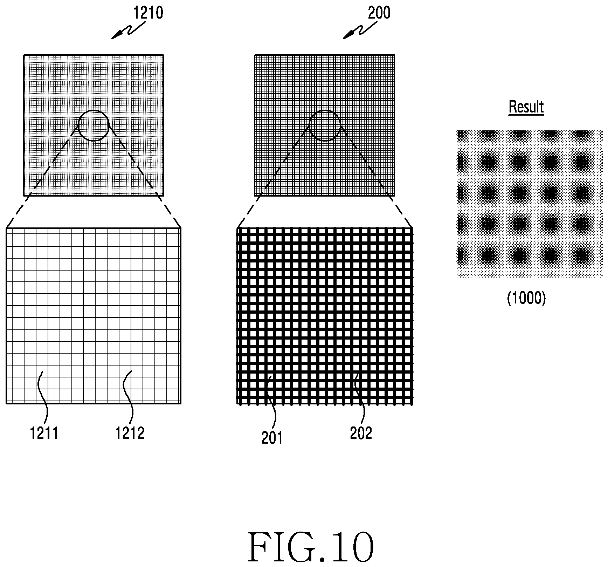

FIG. 10 illustrates a moire pattern 1000 produced in a process in which light reflected by an external object is received in the fingerprint sensor 130, according to an embodiment.

Referring to FIG. 10, the light reflected from the external object may pass through the plurality of light transmission holes 201 of the printed pattern 200 and thereafter may be sampled by a light detection region 1211 of a plurality of pixels 1210 of the fingerprint sensor 130.

In an embodiment, the plurality of pixels 1210 may be included in the fingerprint sensor 130. The plurality of pixels 1210 may include the light detection region 1211 and a light block region 1212.

In an embodiment, the printed pattern 200 may include the plurality of light transmission holes 201 and the light block region 202.

In an embodiment, the light reflected by the external object may pass through the plurality of light transmission holes of the printed pattern 200. The light passing through the printed pattern 200 may be detected by the plurality of pixels 1210 of the fingerprint sensor 130. In this case, the moire pattern 1000 may be produced according to a shape of the plurality of pixels 1210 and a shape of the printed pattern 200. The moire pattern 1000 may act as noise and thus may be a factor of deteriorating image quality of an image obtained by the fingerprint sensor 130.

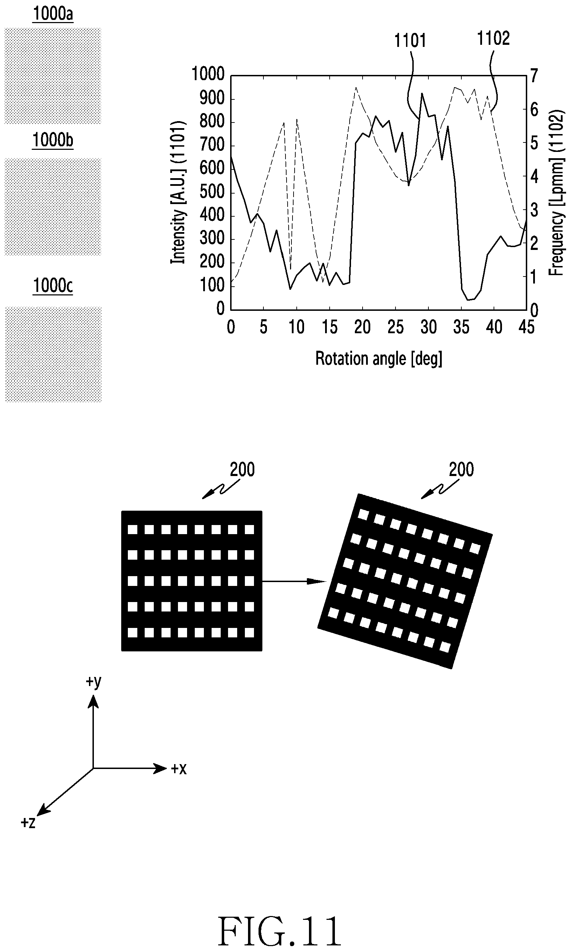

In an embodiment, a method of reducing the moire pattern 1000 will be described with reference to FIG. 11.

FIG. 11 illustrates an arrangement of the printed pattern 200 controlled to reduce the moire pattern 1000 included in the image obtained through the fingerprint sensor 130, according to an embodiment.

In an embodiment, since the moire pattern 1000 is produced due to periodic overlapping of the printed pattern 200 and the plurality of pixels 1210 included in the fingerprint sensor 130, the moire pattern 1000 may be reduced by changing periods of the printed pattern 200 and/or the plurality of pixels 1210 included in the fingerprint sensor 130 or by controlling a relative angle between the printed pattern 200 and the plurality of pixels 1210 overlapping the fingerprint sensor 130.

In an embodiment, when the pixel size in the plurality of pixels 1210 included in the fingerprint sensor 130 and the distance 's' between the plurality of light transmission holes 201 are determined, the relative angle between the fingerprint sensor 130 and the printed pattern 200 may be controlled at an angle of reducing the moire pattern. For example, in a state where the periods of the printed pattern 200 and the plurality of pixels 1210 included in the fingerprint sensor 130 are fixed, a relative angle against the plurality of pixels 1210 may be controlled by rotating about an axis (e.g., +z axis or -z axis) substantially perpendicular to a plane (e.g., in a first direction (e.g., +z direction of FIG. 1) and a second direction (e.g., +y direction of FIG. 11)) on which the printed pattern 200 is disposed.

Referring to FIG. 11, a moire pattern 1000a may be produced when the angle between the printed pattern 200 and the plurality of pixels 1210 included in the fingerprint sensor 130 is approximately 0 degrees (unit: °). In an embodiment, a moire pattern 1000b may be produced when the angle between the printed pattern 200 and the plurality of pixels 1210 is approximately 5 degrees. In an embodiment, the moire pattern 1000b when the angle between the printed pattern 200 and the plurality of pixels 1210 is approximately 5 degrees may include a pattern with a reduced moire pattern compared to the moire pattern 1000a when the angle is approximately 0 degrees.

Referring to FIG. 11, when the angle between the printed pattern 200 and the plurality of pixels 1210 is approximately 10 degrees, the moire pattern may have minimum intensity. Therefore, a moire pattern 1000c may be obtained when the printed pattern 200 is disposed by rotating approximately 10 degree about an axis perpendicular to a plane on which the printed pattern 200 is disposed. In this case, the moire pattern 1000c may include a pattern with a reduced moire pattern compared to the moire pattern 1000a when the angle between the printed pattern 200 and the plurality of pixels 1210 is approximately 0 degrees and the moire pattern 1000b when the angle between the printed pattern 200 and the plurality of pixels 1210 is approximately 5 degrees.

Although it is illustrated in FIG. 11 that the angle between the printed pattern 200 and the plurality of pixels 1210 is approximately 10 degrees, the moire pattern may vary depending on the period of the printed pattern 200 and the period of the plurality of pixels 1210. Therefore, the angle between the printed pattern 200 and the plurality of pixels 1210, at which the moire pattern has the minimum intensity, may be determined according to the period of the printed pattern 200 and the period of the plurality of pixels 1210.

FIG. 12 is a block diagram of an electronic device in a network environment, according to various embodiments.

Referring to FIG. 12, the electronic device 1201 in the network environment 1200 may communicate with an electronic device 1202 via a first network 1298 (e.g., a short-range wireless communication network), or at least one of an electronic device 1204 or a server 1208 via a second network 1299 (e.g., a long-range wireless communication network). According to an embodiment, the electronic device 1201 may communicate with the electronic device 1204 via the server 1208. According to an embodiment, the electronic device 1201 may include a processor 1220, memory 1230, an input module 1250, a sound output module 1255, a display module 1260, an audio module 1270, a sensor module 1276, an interface 1277, a connecting terminal 1278, a haptic module 1279, a camera module 1280, a power management module 1288, a battery 1289, a communication module 1290, a subscriber identification module (SIM) 1296, or an antenna module 1297. In some embodiments, at least one of the components (e.g., the connecting terminal 1278) may be omitted from the electronic device 1201, or one or more other components may be added in the electronic device 1201. In some embodiments, some of the components (e.g., the sensor module 1276, the camera module 1280, or the antenna module 1297) may be implemented as a single component (e.g., the display module 1260).

The processor 1220 may execute, for example, software (e.g., a program 1240) to control at least one other component (e.g., a hardware or software component) of the electronic device 1201 coupled with the processor 1220, and may perform various data processing or computation. According to one embodiment, as at least part of the data processing or computation, the processor 1220 may store a command or data received from another component (e.g., the sensor module 1276 or the communication module 1290) in volatile memory 1232, process the command or the data stored in the volatile memory 1232, and store resulting data in non-volatile memory 1234. According to an embodiment, the processor 1220 may include a main processor 1221 (e.g., a central processing unit (CPU) or an application processor (AP)), or an auxiliary processor 1223 (e.g., a graphics processing unit (GPU), a neural processing unit (NPU), an image signal processor (ISP), a sensor hub processor, or a communication processor (CP)) that is operable independently from, or in conjunction with, the main processor 1221. For example, when the electronic device 1201 includes the main processor 1221 and the auxiliary processor 1223, the auxiliary processor 1223 may be adapted to consume less power than the main processor 1221, or to be specific to a specified function. The auxiliary processor 1223 may be implemented as separate from, or as part of the main processor 1221.

The auxiliary processor 1223 may control at least some of functions or states related to at least one component (e.g., the display module 1260, the sensor module 1276, or the communication module 1290) among the components of the electronic device 1201, instead of the main processor 1221 while the main processor 1221 is in an inactive (e.g., sleep) state, or together with the main processor 1221 while the main processor 1221 is in an active state (e.g., executing an application). According to an embodiment, the auxiliary processor 1223 (e.g., an image signal processor or a communication processor) may be implemented as part of another component (e.g., the camera module 1280 or the communication module 1290) functionally related to the auxiliary processor 1223. According to an embodiment, the auxiliary processor 1223 (e.g., the neural processing unit) may include a hardware structure specified for artificial intelligence model processing. An artificial intelligence model may be generated by machine learning. Such learning may be performed, e.g., by the electronic device 1201 where the artificial intelligence is performed or via a separate server (e.g.,

the server 1208). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1230 may store various data used by at least one component (e.g., the processor 1220 or the sensor module 1276) of the electronic device 1201. The various data may include, for example, software (e.g., the program 1240) and input data or output data for a command related thereto. The memory 1230 may include the volatile memory 1232 or the non-volatile memory 1234.

The program 1240 may be stored in the memory 1230 as software, and may include, for example, an operating system (OS) 1242, middleware 1244, or an application 1246.

The input module 1250 may receive a command or data to be used by another component (e.g., the processor 1220) of the electronic device 1201, from the outside (e.g., a user) of the electronic device 1201. The input module 1250 may include, for example, a microphone, a mouse, a keyboard, a key (e.g., a button), or a digital pen (e.g., a stylus pen).

The sound output module 1255 may output sound signals to the outside of the electronic device 1201. The sound output module 1255 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1260 may visually provide information to the outside (e.g., a user) of the electronic device 1201. The display module 1260 may include, for example, a display, a hologram device, or a projector and control circuitry to control a corresponding one of the display, hologram device, and projector. According to an embodiment, the display module 1260 may include a touch sensor adapted to detect a touch, or a pressure sensor adapted to measure the intensity of force incurred by the touch.

The audio module 1270 may convert a sound into an electrical signal and vice versa. According to an embodiment, the audio module 1270 may obtain the sound via the input module 1250, or output the sound via the sound output module 1255 or a headphone of an external electronic device (e.g., an electronic device 1202) directly (e.g., wiredly) or wirelessly coupled with the electronic device 1201.

The sensor module 1276 may detect an operational state (e.g., power or temperature) of the electronic device 1201 or an environmental state (e.g., a state of a user) external to the electronic device 1201, and then generate an electrical signal or data value corresponding to the detected state. According to an embodiment, the sensor module 1276 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1277 may support one or more specified protocols to be used for the electronic device 1201 to be coupled with the external electronic device (e.g., the electronic device 1202) directly (e.g., wiredly) or wirelessly. According to an embodiment, the interface 1277 may include, for example, a high definition multimedia interface (HDMI), a universal serial bus (USB) interface, a secure digital (SD) card interface, or an audio interface.

A connecting terminal 1278 may include a connector via which the electronic device 1201 may be physically connected with the external electronic device (e.g., the electronic device 1202). According to an embodiment, the connecting terminal 1278 may include, for example, a HDMI connector, a USB connector, a SD card connector, or an audio connector (e.g., a headphone connector).

The haptic module 1279 may convert an electrical signal into a mechanical stimulus (e.g., a vibration or a movement) or electrical stimulus which may be recognized by a user via his tactile sensation or kinesthetic sensation. According to an embodiment, the haptic module 1279 may include, for example, a motor, a piezoelectric element, or an electric stimulator.

The camera module 1280 may capture a still image or moving images. According to an embodiment, the camera module 1280 may include one or more lenses, image sensors, image signal processors, or flashes.

The power management module 1288 may manage power supplied to the electronic device 1201. According to one embodiment, the power management module 1288 may be implemented as at least part of, for example, a power management integrated circuit (PMIC).

The battery 1289 may supply power to at least one component of the electronic device 1201. According to an embodiment, the battery 1289 may include, for example, a primary cell which is not rechargeable, a secondary cell which is rechargeable, or a fuel cell.

The communication module 1290 may support establishing a direct (e.g., wired) communication channel or a wireless communication channel between the electronic device 1201 and the external electronic device (e.g., the electronic device 1202, the electronic device 1204, or the server 1208) and performing communication via the established communication channel. The communication module 1290 may include one or more communication processors that are operable independently from the processor 1220 (e.g., the application processor (AP)) and supports a direct (e.g., wired) communication or a wireless communication. According to an embodiment, the communication module 1290 may include a wireless communication module 1292 (e.g., a cellular communication module, a short-range wireless communication module, or a global navigation satellite system (GNSS) communication module) or a wired communication module 1294 (e.g., a local area network (LAN) communication module or a power line communication (PLC) module). A corresponding one of these communication modules may communicate with the external electronic device via the first network 1298 (e.g., a short-range communication network, such as BluetoothTM, wireless-fidelity (Wi-Fi) direct, or infrared data association (IrDA)) or the second network 1299 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1292 may identify and authenticate the electronic device 1201 in a communication network, such as the first network 1298 or the second network 1299, using subscriber information (e.g., international mobile subscriber identity (IMSI)) stored in the subscriber identification module 1296.

The wireless communication module 1292 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1292 may support a high-frequency band (e.g., the mmWave band) to achieve, e.g., a high data transmission rate. The wireless communication module 1292 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1292 may support various requirements specified in the electronic device 1201, an external electronic device (e.g., the electronic device 1204), or a network system (e.g., the second network 1299). According to an embodiment, the wireless communication module 1292 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1297 may transmit or receive a signal or power to or from the outside (e.g., the external electronic device) of the electronic device 1201. According to an embodiment, the antenna module 1297 may include an antenna including a radiating element composed of a conductive material or a conductive pattern formed in or on a substrate (e.g., a printed circuit board (PCB)). According to an embodiment, the antenna module 1297 may include a plurality of antennas (e.g., array antennas). In such a case, at least one antenna appropriate for a communication scheme used in the communication network, such as the first network 1298 or the second network 1299, may be selected, for example, by the communication module 1290 (e.g., the wireless communication module 1292) from the plurality of antennas. The signal or the power may then be transmitted or received between the communication module 1290 and the external electronic device via the selected at least one antenna. According to an embodiment, another component (e.g., a radio frequency integrated circuit (RFIC)) other than the radiating element may be additionally formed as part of the antenna module 1297.

According to various embodiments, the antenna module 1297 may form a mm Wave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1201 and the external electronic device 1204 via the server 1208 coupled with the second network 1299. Each of the electronic devices 1202 or 1204 may be a device of a same type as, or a different type, from the electronic device 1201. According to an embodiment, all or some of operations to be executed at the electronic device 1201 may be executed at one or more of the external electronic devices 1202, 1204, or 1208. For example, if the electronic device 1201 should perform a function or a service automatically, or in response to a request from a user or another device, the electronic device 1201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1201.

The electronic device 1201 may provide the outcome, with or without further processing of the outcome, as at least part of a reply to the request. To that end, a cloud computing, distributed computing, mobile edge computing (MEC), or client-server computing technology may be used, for example. The electronic device 1201 may provide ultra low-latency services using, e.g., distributed computing or mobile edge computing. In another embodiment, the external electronic device 1204 may include an internet-of things (IoT) device. The server 1208 may be an intelligent server using machine learning and/or a neural network. According to an embodiment, the external electronic device 1204 or the server 1208 may be included in the second network 1299. The electronic device 1201 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1240) including one or more instructions that are stored in a storage medium (e.g., internal memory 1236 or external memory 1238) that is readable by a machine (e.g., the electronic device 1201). For example, a processor (e.g., the processor 1220) of the machine (e.g., the electronic device 1201) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to various embodiments, an electronic device may include a fingerprint sensor, a display including a fingerprint detection region corresponding to a region in which the fingerprint sensor is disposed and a fingerprint non-detection region distinct from the fingerprint sensor detection region, wherein the fingerprint detection region of the display include a light-emitting element layer including a pixel region and a non-pixel region around the pixel region, and a first layer disposed on an upper side of the light-emitting element layer and including a first region overlapping the pixel region and a second region overlapping the non-pixel region, and a printed pattern disposed on at least one of the non-pixel region and the second region, wherein the printed pattern includes a plurality of light-transmitting holes through which light reflected by an external object passes.

According to an embodiment, the printed pattern may include a first printed pattern arranged by extending in a first direction and a second printed pattern arranged by extending in a second direction crossing the first direction, and may include the plurality of light transmission holes defined based on a combination of the first printed pattern and the second printed pattern.

According to an embodiment, a distance between the plurality of light transmission holes may be determined based on a lens included in the fingerprint sensor.

According to an embodiment, the lens included in the fingerprint sensor may include a lens type having a magnification greater than 1x and a lensless type having a magnification of 1x.

According to an embodiment, when the lens included in the fingerprint sensor is the lens type, the fingerprint sensor may be disposed between two consecutive patterns of a diffraction pattern produced while light reflected by the external object passes through the plurality of light transmission holes.

According to an embodiment, when the lens included in the fingerprint sensor is the lens type, a distance 's' between the plurality of light transmission holes may be determined based on a wavelength of light reflected by the external object, a distance between the printed pattern and the fingerprint sensor, and a width of the fingerprint sensor.

According to an embodiment, when the lens included in the fingerprint sensor is the lensless type, a distance 's' between the plurality of light transmission holes may be determined based on a wavelength reflected by the external object, a distance between the printed pattern and the fingerprint sensor, and a size of a single pixel in the plurality of pixels.

According to an embodiment, when the lens included in the fingerprint sensor is the lensless type, a diameter of the plurality of light transmission holes may be greater than half a distance between the plurality of light transmission holes.

According to an embodiment, when the lens included in the fingerprint sensor is the lensless type, a period of a diffraction pattern produced while light reflected by the external object passes through the plurality of light transmission holes may be less than a size of a single pixel in the plurality of pixels of the fingerprint sensor.

According to an embodiment, the electronic device may further include an encapsulation layer disposed between the light emitting element layer and the first layer.

According to an embodiment, the first layer may include a color filter layer, and the color filter layer may include a color filter disposed to the first region.

According to an embodiment, the electronic device may further include a Pixel Define Layer (PDL) disposed to the non-pixel region of the light emitting element layer.

According to an embodiment, the electronic device may further include an organic light emitting material disposed to a pixel region of the light emitting element layer.

According to an embodiment, the printed pattern may be disposed to minimize moire noise produced when light reflected by the external object is sensed by the plurality of pixels of the fingerprint sensor after passing through the plurality of light transmission holes of the printed pattern.

According to an embodiment, a green color filter may be disposed to the first region and second region of the first layer, and the printed pattern may be disposed to the non-pixel region of the light emitting element layer.

According to an embodiment, when a lens type-lens is included in the fingerprint sensor, the distance 's' between the plurality of light transmission holes may correspond to a value less than a value r1 determine by Equation 1. The Equation 1 consists of $r1 = \dfrac{a \times b}{c}$ , where a denotes a wavelength of light reflected by the external object, b denotes a distance between the printed pattern and the fingerprint sensor, and c denotes a width of the fingerprint sensor.

According to an embodiment, when a lensless type-lens is included in the fingerprint sensor, the distance 's' between the plurality of light transmission holes may correspond to a value greater than a value r2 determined by Equation 2. The Equation 2 consists of $r2 = \dfrac{a \times b}{d \times 2}$, where a denotes a wavelength of light reflected by the external object, b denotes a distance between the printed pattern and the fingerprint sensor, and d denotes a size of a single pixel in the plurality of pixels.

A display module according to various embodiments of the disclosure may include a fingerprint sensor, a display including a fingerprint detection region corresponding to a region in which the fingerprint sensor is disposed and a fingerprint non-detection region distinct from the fingerprint sensor detection region, wherein the fingerprint detection region includes a light-emitting element layer including a pixel region and a non-pixel region around the pixel region, and a first layer disposed on an upper side of the light-emitting element layer and including a first region overlapping the pixel region and a second region overlapping the non-pixel region, and a printed pattern disposed on at least one of the non-pixel region and the second region, wherein the printed pattern includes a plurality of light-transmitting holes through which light reflected by an external object passes.

According to an embodiment, a distance between the plurality of light transmission holes may be determined based on a type of a lens included in the fingerprint sensor.

According to an embodiment, the electronic device may further include an encapsulation layer disposed between the light emitting element layer and the first layer.

**Claims**

1. An electronic device comprising:

    a fingerprint sensor;
    a display including a fingerprint detection region corresponding to a region in which the fingerprint sensor is disposed and a fingerprint non-detection region distinct from the fingerprint sensor detection region, wherein the fingerprint detection region of the display includes a light-emitting element layer including a pixel region and a non-pixel region around the pixel region, and a first layer disposed on an upper side of the light-emitting element layer and including a first region overlapping the pixel region and a second region overlapping the non-pixel region; and
    a printed pattern disposed on at least one of the non-pixel region and the second region, wherein the printed pattern includes a plurality of light-transmitting holes through which light reflected by an external object passes.

2. The electronic device of claim 1, wherein the printed pattern includes a first printed pattern arranged by extending in a first direction and a second printed pattern arranged by extending in a second direction crossing the first direction, and includes the plurality of light transmission holes defined based on a combination of the first printed pattern and the second printed pattern.

3. The electronic device of claim 1, wherein a distance between the plurality of light transmission holes is determined based on a lens included in the fingerprint sensor.

4. The electronic device of claim 3, wherein the lens included in the fingerprint sensor includes a lens type having a magnification greater than 1x and a lensless type having a magnification of 1x.

5. The electronic device of claim 4, wherein, when the lens included in the fingerprint sensor is the lens type, the fingerprint sensor is disposed between two consecutive patterns of a diffraction pattern produced while light reflected by the external object passes through the plurality of light transmission holes.

6. The electronic device of claim 4, wherein, when the lens included in the fingerprint sensor is the lens type, a distance 's' between the plurality of light transmission holes is determined based on a wavelength of light reflected by the external object, a distance between the printed pattern and the fingerprint sensor, and a width of the fingerprint sensor.

7. The electronic device of claim 4, wherein, when the lens included in the fingerprint sensor is the lensless type, a distance 's' between the plurality of light transmission holes is determined based on a wavelength reflected by the external object, a distance between the printed pattern and the fingerprint sensor, and a size of a single pixel in the plurality of pixels.

8. The electronic device of claim 4, wherein, when the lens included in the fingerprint sensor is the lensless type, a diameter of the plurality of light transmission holes is greater than half a distance between the plurality of light transmission holes.

9. The electronic device of claim 4, wherein, when the lens included in the fingerprint sensor is the lensless type, a period of a diffraction pattern produced while light reflected by the external object passes through the plurality of light transmission holes is less than a size of a single pixel in the plurality of pixels of the fingerprint sensor.

10. The electronic device of claim 1, further comprising an encapsulation layer disposed between the light emitting element layer and the first layer.

11. The electronic device of claim 1, wherein the first layer includes a color filter layer, and the color filter layer includes a color filter disposed to the first region.

12. The electronic device of claim 1, further comprising a Pixel Define Layer (PDL) disposed to the non-pixel region of the light emitting element layer.

13. The electronic device of claim 1, further comprising an organic light emitting material disposed to a pixel region of the light emitting element layer.

14. The electronic device of claim 1, wherein the printed pattern is disposed to minimize moire noise produced when light reflected by the external object is sensed by the plurality of pixels of the fingerprint sensor after passing through the plurality of light transmission holes of the printed pattern.

15. The electronic device of claim 1, wherein a green color filter is disposed to the first region and second region of the first layer, and the printed pattern is disposed to the non-pixel region of the light emitting element layer.

+z

-x        +y

-y        +x

-z

101

140  1113

150

110A

1112

120

1111

110C

1114

110B

104

105

130

131

113

110

**FIG.1**

120

| Cover window | | | 121 |

FIG.2

EP 4 343 847 A1

FIG.3A

EP 4 343 847 A1

| Cover Window | | | | | }—121 | 120b |
|---|---|---|---|---|---|---|
| (1222b) | (1221b) | (1222b) | (1221b) | (1222b) | }—122b | |
| Encapsulation Layer | | | | | }—123 | |
| First Electrode | | First Electrode | | First Electrode | | |
| (1242b) | (1241b) | (1242b) | (1241b) | (1242b) | }—124b | |
| | Second Electrode | | Second Electrode | | | |
| TFT | | | | | }—125 | |

Z

X

(b)

# FIG.3B

Electronic Device (101)

160

Processor

120

Display

130

Fingerprint Sensor

FIG.4

FIG.5

200

120b

122b

(1221b)        (1221b)        (1221b)

122b

Encapsulation Layer — 123

| First Electrode | | First Electrode | | First Electrode |

(1242b) | (1241b) | (1242b) | (1241b) | (1242b)

124b

| Second Electrode | | Second Electrode |

(a)

# FIG.6A

200                                             120b

| (1222b) | (1221b) | (1222b) | (1221b) | (1222b) | 122b |

Encapsulation Layer     123

First Electrode

(1241b)                         (1241b)     124b

Second Electrode                      Second Electrode

(b)

# FIG.6B

200a 200b

120b

(1221b)

(1221b)

122b

Encapsulation Layer

123

First Electrode

(1241b)

(1241b)

124b

Second Electrode

Second Electrode

(c)

# FIG.6C

26

EP 4 343 847 A1

120a

| | | | |
|---|---|---|---|
| (1222a) Red Color Filter (1221a) (1222a) | Blue Color Filter (1221a) (1222a) | Green Color Filter (1221a) (1222a) | Red Color Filter (1221a) (1222a) | 122a

Encapsulation Layer — 123

| (1242a) (1241a) (1242a) | (1241a) (1242a) | (1241a) (1242a) | (1241a) (1242a) | 124a

(a)

# FIG.7A

120c

122c
123
124c

Red Color Filter (1221a)
(1222c)

Green Color Filter (1221c)

Blue Color Filter (1221a)
(1222c)

Red Color Filter (1221a)
(1222c)

Encapsulation Layer

(1242c)
(1241c)
(1243c)
200
(1244c)
(1243c)
200
(1241c)
(1242c)
(1241c)
(1242c)
(1242c)

(b)

FIG.7B

FIG.8

FIG.9

**FIG.10**

EP 4 343 847 A1

FIG.11

32

FIG.12

## INTERNATIONAL SEARCH REPORT

| International application No. |
| --- |
| **PCT/KR2022/007701** |

| A. | CLASSIFICATION OF SUBJECT MATTER |
| --- | --- |
| | **H01L 27/32**(2006.01)i; **G06V 40/13**(2022.01)i; **H01L 27/146**(2006.01)i; **H01L 51/52**(2006.01)i |

According to International Patent Classification (IPC) or to both national classification and IPC

| B. | FIELDS SEARCHED |
| --- | --- |

Minimum documentation searched (classification system followed by classification symbols)

H01L 27/32(2006.01); G06F 3/042(2006.01); G06K 9/00(2006.01); H01L 27/146(2006.01); H01L 51/50(2006.01); H01L 51/52(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전자 장치(electronic device), 지문 센서(fingerprint sensor), 디스플레이(display), 인쇄 패턴(print pattern), 광 투과 홀(light transmitting hole), 렌즈(lens)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2021-0032923 A (BEIJING XIAOMI MOBILE SOFTWARE CO., LTD.) 25 March 2021 (2021-03-25)<br>See paragraphs [0035]-[0086] and figures 1-5. | 1-2,10-15 |
| A | | 3-9 |
| Y | CN 111564483 A (HEFEI VISIONOX TECHNOLOGY CO., LTD.) 21 August 2020 (2020-08-21)<br>See paragraphs [0046]-[0058] and figures 6-7. | 1-2,10-15 |
| A | KR 10-2019-0066433 A (SAMSUNG ELECTRONICS CO., LTD.) 13 June 2019 (2019-06-13)<br>See paragraphs [0069]-[0093] and figures 4-5. | 1-15 |
| A | KR 10-2019-0050334 A (SAMSUNG DISPLAY CO., LTD.) 13 May 2019 (2019-05-13)<br>See paragraphs [0085]-[0121] and figures 4-6. | 1-15 |

| ✓ Further documents are listed in the continuation of Box C. | ✓ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **16 September 2022** | **16 September 2022** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

# EP 4 343 847 A1

**INTERNATIONAL SEARCH REPORT**

International application No.

**PCT/KR2022/007701**

## C. DOCUMENTS CONSIDERED TO BE RELEVANT

| Category* | Citation of document, with indication, where appropriate, of the relevant passages | Relevant to claim No. |
|---|---|---|
| A | KR 10-2019-0088147 A (SAMSUNG DISPLAY CO., LTD.) 26 July 2019 (2019-07-26) See paragraphs [0066]-[0113] and figures 3a-3b. | 1-15 |

Form PCT/ISA/210 (second sheet) (July 2019)

**INTERNATIONAL SEARCH REPORT**
Information on patent family members

International application No.

**PCT/KR2022/007701**

| Patent document cited in search report | | | Publication date (day/month/year) | Patent family member(s) | | | Publication date (day/month/year) |
|---|---|---|---|---|---|---|---|
| KR | 10-2021-0032923 | A | 25 March 2021 | CN | 112490266 | A | 12 March 2021 |
| | | | | EP | 3792907 | A1 | 17 March 2021 |
| | | | | JP | 2022-503274 | A | 12 January 2022 |
| | | | | US | 11289549 | B2 | 29 March 2022 |
| | | | | US | 2021-0074777 | A1 | 11 March 2021 |
| | | | | WO | 2021-047061 | A1 | 18 March 2021 |
| CN | 111564483 | A | 21 August 2020 | | None | | |
| KR | 10-2019-0066433 | A | 13 June 2019 | US | 2019-0172875 | A1 | 06 June 2019 |
| | | | | WO | 2019-112213 | A1 | 13 June 2019 |
| KR | 10-2019-0050334 | A | 13 May 2019 | CN | 109755275 | A | 14 May 2019 |
| | | | | EP | 3480804 | A1 | 08 May 2019 |
| | | | | EP | 3480804 | B1 | 16 June 2021 |
| | | | | US | 11188728 | B2 | 30 November 2021 |
| | | | | US | 2019-0130155 | A1 | 02 May 2019 |
| KR | 10-2019-0088147 | A | 26 July 2019 | CN | 110047872 | A | 23 July 2019 |
| | | | | EP | 3514726 | A1 | 24 July 2019 |
| | | | | US | 11003266 | B2 | 11 May 2021 |
| | | | | US | 2019-0220121 | A1 | 18 July 2019 |

Form PCT/ISA/210 (patent family annex) (July 2019)